(19) **Europäisches Patentamt**

**European Patent Office**

**Office européen des brevets**

(11) **EP 0 898 313 B1**

(12) **FASCICULE DE BREVET EUROPEEN**

(45) Date de publication et mention
de la délivrance du brevet:
**12.11.2003 Bulletin 2003/46**

(51) Int Cl.⁷: **H01L 41/107**

(21) Numéro de dépôt: **97114229.4**

(22) Date de dépôt: **18.08.1997**

(54) **Transformateur piézo-électrique**

Piezoelektrischer Transformator

Piezoelectric transformer

(84) Etats contractants désignés:
**CH DE FR GB IT LI**

(43) Date de publication de la demande:
**24.02.1999 Bulletin 1999/08**

(73) Titulaire: **ETA SA Manufacture Horlogère Suisse
2540 Grenchen (CH)**

(72) Inventeur: **Le Letty, Ronan
38000 Grenoble (FR)**

(74) Mandataire: **Balsters, Robert et al
I C B,
Ingénieurs Conseils en Brevets S.A.,
7, rue des Sors
2074 Marin (CH)**

(56) Documents cités:
• **PATENT ABSTRACTS OF JAPAN vol. 010, no. 313 (E-448), 24 octobre 1986 & JP 61 125179 A (RION CO LTD), 12 juin 1986,**

## Description

La présente invention a pour objet un transformateur piézo-électrique comportant :

- un corps en un matériau piézo-électrique ayant une première et une deuxième face ainsi qu'une surface latérale externe;
- une pluralité d'électrodes primaires disposées sur ledit corps pour exciter une vibration dudit corps en réponse à une tension primaire alternative; et
- une pluralité d'électrodes secondaires disposées sur ledit corps pour produire une tension secondaire en réponse à ladite vibration;

ladite surface externe ayant, en l'absence de ladite vibration, la forme d'un premier cylindre circulaire ayant un axe de symétrie circulaire et lesdites faces ayant chacune une partie externe située du côté de ladite surface latérale externe et une partie interne entourée par ladite partie externe.

Un transformateur piézo-électrique présentant ces caractéristiques est décrit dans le brevet US 2,974,296 où il est représenté par la figure 1. Le corps de ce transformateur a la forme d'un cylindre creux allongé polarisé axialement. La tension primaire est appliquée entre deux électrodes entourant le corps de part et d'autre du milieu de sa longueur, de manière que ce corps vibre dans un mode longitudinal. La tension secondaire est recueillie entre deux électrodes entourant le corps, chacune à une des extrémités de ce dernier.

En plus des inconvénients qui sont communs à tous les transformateurs connus et qui seront mentionnés plus loin, ce transformateur présente l'inconvénient d'être relativement difficile à fabriquer en grandes séries du fait de sa forme de cylindre circulaire creux et allongé. Son prix de revient est donc relativement élevé.

Un autre transformateur présentant également les caractéristiques ci-dessus est aussi décrit dans le même brevet US 2,974,296, où il est représenté par la figure 8. Le corps de ce transformateur a la forme d'un disque circulaire dont la partie centrale est polarisée axialement et la partie externe, annulaire, est polarisée radialement. La tension primaire est appliquée entre deux électrodes disposées de part et d'autre de la partie centrale du corps, de manière que ce dernier vibre dans un mode radial. La tension secondaire est recueillie entre l'une de ces dernières électrodes et une troisième électrode disposée sur la surface latérale du corps.

Encore un autre transformateur présentant les caractéristiques ci-dessus est décrit dans le même brevet US 2,974,296, où il est représenté par la figure 9. Le corps de ce transformateur a la forme d'un anneau circulaire dont une première moitié, dans une vue en plan, est polarisée axialement. La deuxième moitié de cet anneau est formée de deux parties polarisées tangentiellement, les sens de polarisation de ces deux parties étant opposés l'un à l'autre. La tension primaire est appliquée entre deux électrodes disposées de part et d'autre de la première moitié de l'anneau, de manière que le corps vibre dans ce qui est appelé un mode tangentiel. La tension secondaire est recueillie entre l'une de ces deux électrodes et une troisième électrode entourant la deuxième moitié de l'anneau à l'endroit où les deux parties polarisées en sens inverse se rejoignent.

Les deux transformateurs qui viennent d'être décrits présentent aussi, entre autres, l'inconvénient d'être relativement difficiles à fabriquer, du fait que leur corps comporte plusieurs parties qui doivent être différemment polarisées. Leur prix de revient est donc également relativement élevé.

Les moyens qui fournissent aux transformateurs connus décrits ci-dessus la tension primaire nécessaire à leur fonctionnement sont évidemment agencés de manière que le corps de ceux-ci vibre à une des fréquences de résonance de son mode de vibration. La fréquence de la tension secondaire produite en réponse à cette vibration est évidemment égale à la fréquence de cette dernière. La fréquence minimale de cette tension secondaire est donc égale à la fréquence de résonance fondamentale du mode dans lequel vibre le corps du transformateur.

On sait d'autre part que, d'une manière générale, la fréquence de résonance fondamentale d'un objet quelconque vibrant dans un de ses modes de vibration, et donc notamment du corps d'un transformateur piézo-électrique, dépend entre autres des dimensions de cet objet et que, toutes autres choses étant égales, cette fréquence de résonance fondamentale est d'autant plus élevée que ces dimensions sont petites.

Il découle de ce qui précède ainsi que des caractéristiques des transformateurs connus mentionnés ci-dessus que, si l'on désire utiliser un de ces transformateurs connus dans un dispositif où la place à disposition est très limitée, la fréquence de résonance fondamentale du corps de ce transformateur sera obligatoirement élevée, de même bien entendu que la fréquence de la tension secondaire fournie par ce transformateur.

Un exemple d'un tel dispositif où la pièce disponible est très limitée est constitué par une montre-bracelet dont le boîtier, qui n'a généralement pas plus de trois ou quatre centimètres de diamètre intérieur, doit contenir de nombreux composants.

L'homme du métier verra facilement que si l'on désire placer dans une montre-bracelet un transformateur piézo-électrique connu tel que ceux qui ont été mentionnés ci-dessus, les dimensions du corps de ce transformateur connu doivent être tellement faibles que la fréquence de résonance fondamentale de ce corps, et donc la fréquence minimale de la tension secondaire produite par ce transformateur, a une valeur supérieure à cent kilohertz, pouvant atteindre, selon le cas, plusieurs mégahertz.

L'utilisation d'une tension alternative ayant une fréquence aussi élevée peut parfois poser des problèmes.

Ainsi, par exemple, les pertes dues aux condensateurs parasites formés inévitablement par les divers conducteurs soumis à cette tension peuvent devenir excessives, et la capacité de ces condensateurs parasites peut perturber le fonctionnement normal du dispositif.

De même, la consommation du circuit destiné à fournir au transformateur sa tension primaire, qui doit évidemment avoir la même fréquence que la tension secondaire, peut devenir excessive puisque cette consommation est en général d'autant plus grande que cette fréquence est élevée.

En outre, une tension ayant une fréquence aussi élevée ne peut pas être utilisée à n'importe quelles fins.

Ainsi, par exemple, on sait qu'un dispositif d'éclairage ou d'affichage électroluminescent, qu'il est souvent avantageux d'utiliser dans une montre, doit être alimenté par une tension alternative ayant une amplitude de quelques dizaines de volts. Or une montre est généralement alimentée par une pile ou un accumulateur fournissant une tension continue de l'ordre de 1,5 à 3 volts. Une telle tension continue peut être facilement convertie en une tension alternative à l'aide d'un circuit électronique simple, mais l'amplitude de cette tension alternative est évidemment aussi de l'ordre de 1,5 à 3 volts.

Il est donc nécessaire de prévoir un transformateur pour alimenter un dispositif électroluminescent dans une montre, et un transformateur piézo-électrique serait à première vue particulièrement bien adapté à cet usage.

Mais on sait également que la durée de vie d'un dispositif électroluminescent diminue rapidement si la fréquence de sa tension d'alimentation dépasse quelques dizaines de kilohertz, par exemple 30 ou 40 kilohertz. Un tel dispositif ne peut donc pas être alimenté par la tension fournie par un transformateur piézo-électrique connu, la fréquence de cette tension étant beaucoup trop élevée.

On peut mentionner ici que d'autres transformateurs piézo-électriques sont également décrits dans le brevet US 2,974,296 déjà mentionné ainsi que dans les brevets US 5,241,236, US 5,365,141, US 5,371,430 et US 5,440,195. Mais ces transformateurs ne peuvent pas être utilisés pour résoudre le problème mentionné ci-dessus car, lorsque leur encombrement est faible, la fréquence de résonance fondamentale du mode de vibration de leur corps est également très élevée. Il faut en outre noter que le corps de tous ces transformateurs a la forme d'un parallélépipède rectangle, et que ces transformateurs ne répondent donc pas à la définition générale donnée ci-dessus.

Un but de la présente invention est donc de proposer un transformateur piézo-électrique qui répond à cette définition générale mais qui a des dimensions suffisamment faibles pour qu'il puisse être facilement utilisé dans un dispositif où la place disponible est limitée, tout en étant agencé de manière que son corps vibre dans un mode ayant une fréquence fondamentale suffisamment basse pour que la tension secondaire qu'il produit soit utilisable dans tous les cas où la fréquence de la tension secondaire produite par un transformateur connu ayant le même encombrement est trop élevée.

Ce but est atteint par la transformateur piézo-électrique dont les caractéristiques sont énumérées dans la revendication 1 annexée.

D'autres buts et avantages de la présente invention seront rendus évidents par la description de quelques-unes de ses formes d'exécution choisies à titre d'exemples non limitatif, description qui va être faite ci-dessous à l'aide du dessin annexé dans lequel :

- la figure 1 représente schématiquement une première face d'un transformateur piézo-électrique selon la présente invention;
- la figure 2 représente schématiquement une coupe du transformateur de la figure 1 faite selon l'axe II-II de cette figure 1;
- la figure 3 représente schématiquement la deuxième face du transformateur de la figure 1;
- la figure 4 illustre schématiquement une manière de faire fonctionner le transformateur des figures 1 à 3;
- la figure 5 illustre schématiquement la déformation du corps du transformateur des figures 1 à 3;
- la figure 6 illustre schématiquement une caractéristique du corps du transformateur des figures 1 à 3;
- la figure 7 représente schématiquement une autre forme d'exécution du transformateur selon la présente invention;
- la figure 8 illustre schématiquement une manière de faire fonctionner le transformateur de la figure 7; et
- la figure 9 illustre schématiquement une autre manière de faire fonctionner le transformateur de la figure 7.

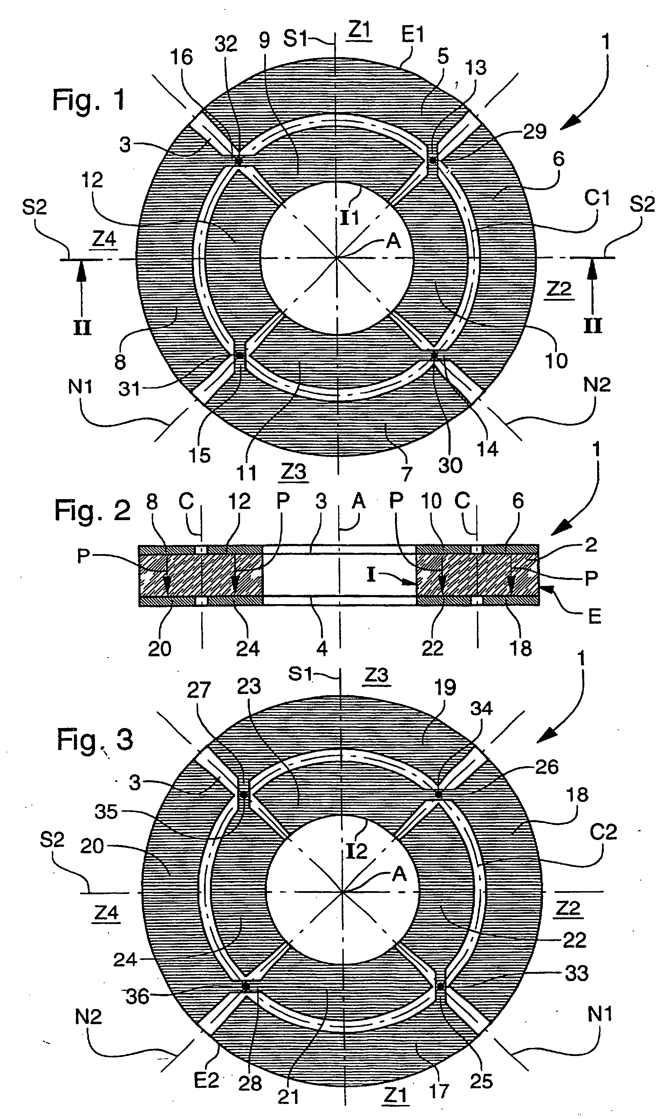

Les figures 1 à 3 représentent schématiquement une forme d'exécution du transformateur selon la présente invention, désignée par la-référence générale 1..

La transformateur 1 comporte un corps 2 formé d'une seule pièce d'un matériau piézo-électrique dont la nature ne sera pas précisée car il peut être l'un quelconque des divers matériaux piézo-électriques bien connus des spécialistes.

Lorsque le transformateur 1 ne fonctionne pas, le corps 2 a la forme d'un anneau cylindrique ayant deux faces planes 3 et 4 parallèles l'une à l'autre et respectivement représentées aux figures 1 et 3.

Les surfaces latérales extérieure et intérieure du corps 2 ont chacune la forme d'un cylindre circulaire droit ayant un axe de symétrie circulaire désigné par la référence A. Ces surfaces latérales extérieure et intérieure ainsi que les cylindres qui les constituent seront respectivement désignées par les références E et I. En outre, les intersections de ces surfaces latérales E et I avec les plans des faces 3 et 4, qui constituent les contours extérieur et intérieur de ces faces 3 et 4 et qui sont évidemment des cercles centrés sur l'axe A, seront respectivement désignées par les références E1, E2, I1 et I2.

Pour une raison qui sera rendue évidente plus loin, on a représenté en traits mixtes dans la figure 2 avec la référence C le cylindre circulaire droit qui a un axe confondu avec l'axe A et un diamètre égal à la moyenne arithmétique des diamètres des cylindres constituant les surfaces latérales E et I. En outre, les tracés de ce cylindre C dans les faces 3 et 4 ont également été représentées aux figures 1 et 3 en traits mixtes avec les références respectives C1 et C2.

La matériau piézo-électrique du corps 2 est polarisé uniformément dans une direction parallèle à l'axe A et dans un sens allant de la face 3 à la face 4. Cette polarisation est symbolisée par les flèches P représentées à la figure 2.

La transformateur 2 comporte encore huit électrodes disposées sur la face 3 du corps 2 et désignées par les références 5 à 12.

Parmi celles-ci, les électrodes 5 à 8 sont disposées à la périphérie de la face 3, à l'extérieur du cercle C1. Ces électrodes 5 à 8 occupent donc un peu moins de la moitié de la largeur de cette face 3 et s'inscrivent chacune dans un angle au centre légèrement inférieur à 90°. En outre, ces électrodes 5 à 8 sont isolées électriquement les unes des autres.

Pour une raison qui sera rendue évidente plus loin, on a également représenté dans les figures 1 et 3, avec les références N1 et N2, les deux plans qui se coupent sur l'axe A en formant quatre angles de 90° et qui passent entre les électrodes 5 et 6 d'une part et 7 et 8 d'autre part et, respectivement, entre les électrodes 5 et 8 d'une part et 6 et 7 d'autre part. Les traces de ces plans N1 et N2 sont indiquées dans les figures 1 et 3 par des traits mixtes désignés par ces même références. En outre, les quatre zones de l'espace qui sont définies par ces plans Ni et N2 et qui contiennent chacune une des électrodes 5 à 8 seront respectivement désignées par les références Z1 à Z4.

Les électrodes 9 à 12 sont disposées sur la partie interne de la face 3 du corps 2, à l'intérieur du cercle C1, et occupent également un peu moins de la moitié de la largeur de cette face 3 tout en laissant un espace d'isolation entre elles et les électrodes 5 à 8. Ces électrodes 9 à 12 s'inscrivent également chacune dans un angle au centre légèrement inférieur à 90°, et sont respectivement situées dans les zones Z1 à Z4 définies ci-dessus.

Les électrodes 9 à 12 sont aussi isolées électriquement les unes des autres, mais chacune d'entre elles est reliée à une, et une seule, des électrodes 5 à 8 par des pistes conductrices désignées par les références 13 à 16.

Plus précisément, les pistes 13 à 16 relient respectivement les électrodes 5 et 10, 6 et 11, 7 et 12, et 8 et 9. En outre, les pistes 13 à 16 sont disposées de manière que chacune d'entre elles englobe un des points où les traces de plans N1 et N2 coupent le cercle moyen C1.

Le transformateur 1 comporte en outre huit autres électrodes disposées sur la face 4 du corps 2 et désignées par les références 17 à 24. Ces électrodes 17 à 24 sont respectivement situées en regard des électrodes 5 à 12 et sont semblables à ces dernières. Ces électrodes 17 à 24 ne seront donc pas décrites plus en détail. On mentionnera simplement que des pistes conductrices 25 à 28 relient respectivement les électrodes 17 et 22, 18 et 23, 19 et 24, et 20 et 21. En outre, ces pistes 25 à 28 sont disposées de manière que chacune d'entre elles englobe un des points où les traces des plans N1 et N2 coupent le cercle C2.

Il faut noter que l'épaisseur des électrodes 6, 8, 10, 12, 18, 20, 22 et 24 visibles en coupe dans la figure 2 a été fortement exagérée pour améliorer la clarté de cette figure 2. L'homme du métier comprendra que ces électrodes, ainsi que toutes celles qui ne sont pas visibles et que les pistes conductrices 13 à 16 et 25 à 28, sont réalisées de manière classique par simple dépôt sur les faces 3 et 4 du corps 2 d'une couche métallique extrêmement mince.

Le transformateur 1 comporte encore des moyens de connexion de ses électrodes 5 à 12 et 17 à 24 avec les circuits qui lui fournissent la tension d'excitation de la vibration de son corps 2 et qui utilisent la tension résultant de cette vibration. Cette vibration et la manière dont elle produit cette dernière tension seront décrites plus loin.

Dans le présent exemple, ces moyens de connexion sont constitués par des tiges 29 à 36 en matériau conducteur ayant chacune une extrémité fixée, par exemple par soudure, à l'une des pistes conductrices 13 à 16 et 25 à 28.

En outre, et pour une raison qui sera rendue évident plus loin, ces tiges 29 à 36 sont de préférence fixées à ces pistes 13 à 16 et 25 à 28 aux points où les traces des plans N1 et N2 coupent respectivement les cercles C1 et C2, comme cela est représenté aux figures 1 et 3.

En lisant la description du fonctionnement du transformateur 1 qui sera faite plus loin, l'homme du métier comprendra facilement que ces tiges 29 à 36, ou tout au moins certaines d'entre elles, peuvent également servir à fixer mécaniquement le transformateur 1 sur un support adéquat.

Avant de commencer la description du fonctionnement du transformateur 1, on relèvera que ce dernier comporte deux plans de symétrie S1 et S2 perpendiculaires l'un à l'autre, qui sont en même temps les plans bissecteurs des angles formés par les plans N1 et N2 mentionnés ci-dessus. Les traces de ces plans S1 et S2 sont indiquées dans les figures 1 et 3 par des traits mixtes portant les mêmes références.

On voit que chacune des électrodes 5, 7, 9, 11, 17, 19, 21 et 23 est symétrique par rapport au plan S1, et que chacune des électrodes 6, 8, 10, 12, 18, 20, 22 et 24 est symétrique par rapport au plan S2. En outre, les électrodes 5, 9, 17 et 21 sont respectivement symétriques des électrodes 7, 11, 19 et 23 par rapport au plan S2, alors que les électrodes 6, 10, 18 et 22 sont respectivement symétriques des électrodes 8, 12, 20 et 24 par rapport au plan S1.

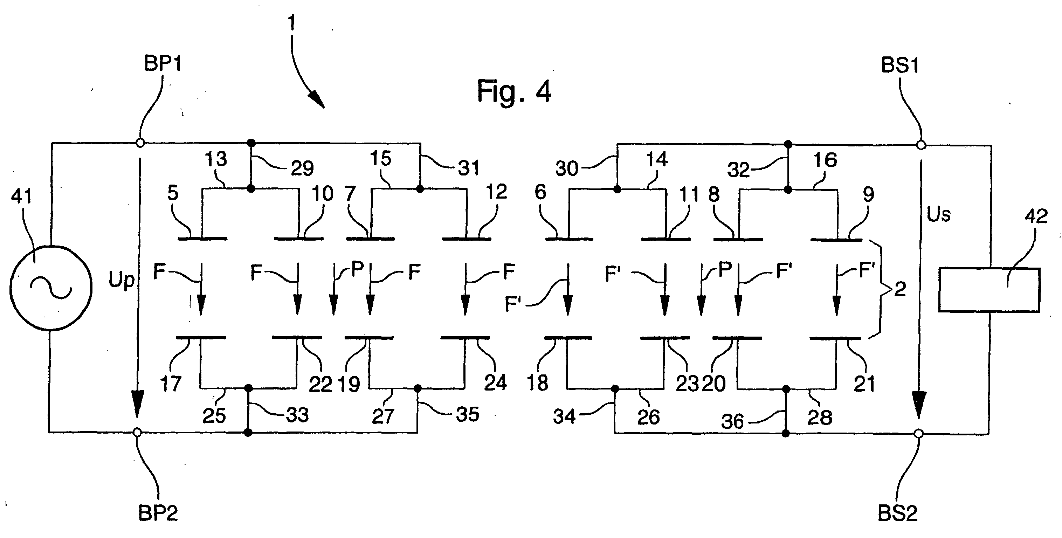

Le fonctionnement du transformateur 1 décrit ci-dessus va être expliqué dans un cas particulier, pris à titre d'exemple non limitatif, illustré par la figure 4.

Dans cet exemple, les tiges de connexion 29 et 31 sont reliées électriquement l'une à l'autre, ainsi qu'à une borne BP1. De même, les tiges de connexion 33 et 35 sont reliées électriquement l'une à l'autre, ainsi qu'à une borne BP2. En outre, les tiges de connexion 30 et 32 sont reliées électriquement l'une à l'autre et à une borne BS1, et les tiges de connexion 34 et 36 sont également reliées électriquement entre elles et à une borne BS2.

Ces liaisons entre les tiges de connexion 29 à 36 et les bornes BP1, BP2, BS1 et BS2 ne seront pas décrites plus en détail car leur réalisation ne pose aucun problème à l'homme du métier.

Comme cela sera rendu évident plus loin, les bornes BP1 et BP2 sont destinées à recevoir la tension alternative appliquée au transformateur 1, ou tension primaire. De même, les bornes BS1 et BS2 sont celles entre lesquelles la tension produite par ce transformateur 1, ou tension secondaire, peut être recueillie. Ces tensions primaire et secondaire seront respectivement appelées tension Up et tension Us.

L'homme du métier comprendra facilement que les bornes BP1 et BP2 peuvent très bien ne pas exister en pratique, la tension Up étant alors appliquée directement entre-les tiges de connexion 29 et 33, par exemple. De même, les bornes BS1 et BS2 peuvent très bien ne pas exister, la tension Us étant alors recueillie directement entre les tiges de connexion 30 et 34, par exemple.

Les électrodes 5 à 12 et 17 à 24 du transformateur 1 ont également et représentées dans la figure 4, de manière très schématique, de même que les pistes conductrices 13 à 16 et 25 à 28.

On voit que, dans ce cas, les électrodes 5, 7, 10 et 12 sont reliées entre elles et avec la borne BP1, de même que les électrodes 17, 19, 22 et 24 avec la borne BP2. En outre, les électrodes 6, 8, 9 et 11 sont reliées entre elles et avec la borne BS1, de même que les électrodes 18, 20, 21 et 23 avec la borne BS2.

En d'autres termes, sur chacune des faces 3 et 4 du corps 2, les électrodes extérieures situées dans deux zones diamétralement opposées sont reliées entre elles et aux électrodes intérieures situées dans les deux autres zones. Ainsi, par exemple, les électrodes extérieures 5 et 7 situées sur la face 3 dans les zones Z1 et, respectivement, Z3, sont reliées aux électrodes intérieures 10 et 12 situées sur la même face 3 mais dans les zones Z2 et, respectivement, Z4.

La source fournissant au transformateur 1 la tension alternative primaire Up et le dispositif alimenté par la tension alternative secondaire Us fournie par le transformateur 1 ont également été représentés à la figure 4 avec les références 41 et, respectivement, 42.

La source 41 ne sera pas décrite car elle peut être réalisée de manière quelconque. En outre, l'homme du métier comprendra facilement que la forme de la tension primaire Up peut être quelconque. Notamment, cette tension Up peut être sinusoïdale, ou avoir la forme généralement qualifiée de carrée dans laquelle elle a alternativement une première valeur constante et une deuxième valeur constante égale en valeur absolue à la première mais de signe opposé à celle-ci.

La nature exacte du dispositif 42 ne sera pas précisée ici car celui-ci peut être n'importe lequel des divers dispositifs qui doivent être alimentés par une tension alternative telle que la tension Us.

On voit que la tension alternative Up provoque l'application d'un champ électrique F, également alternatif, aux quatre parties du corps 2 qui sont respectivement situées entre les paires d'électrodes 5 et 17, 7 et 19, 10 et 22, et 12 et 24. Dans la suite de cette description, ces électrodes 5, 7, 10, 12, 17, 19, 22 et 24 seront appelées électrodes primaires, et les parties du corps 2 qu'elles délimitent seront appelées parties primaires de ce corps 2.

Le champ électrique F a une direction parallèle à celle de l'axe A, et donc à la direction de la polarisation P du matériau du corps 2, et un sens qui est alternativement le même que celui de cette polarisation P et le sens opposé.

De manière bien connue, le couplage électromécanique transverse du champ F avec le matériau du corps 2, appelé couramment couplage électromécanique 31, provoque l'application de contraintes mécaniques aux quatre parties primaires du corps 2 définies ci-dessus. Le champ F ayant alternativement les deux sens mentionnés ci-dessus, ces contraintes mécaniques provoquent alternativement, toujours de manière bien connue, une contraction et une expansion de ces quatre parties primaires dans toutes les directions perpendiculaires à l'axe A.

On voit qu'une première et une deuxième des quatre parties primaires définies ci-dessus, c'est-à-dire celles qui sont situées entre les électrodes 5 et 17 et, respectivement, 7 et 19, sont des parties externes du corps 2 respectivement situées dans une première et une deuxième des quatre zones également définies ci-dessus, c'est-à-dire les zones Z1 et Z3. Cette première et cette deuxième partie primaire sont symétriques l'une de l'autre par rapport au plan S2 et chacune d'elles est symétrique par rapport au plan S1.

On voit également que la troisième et la quatrième partie primaire, c'est-à-dire celles qui sont situées entre les électrodes 10 et 22, et, respectivement, 12 et 24, sont des parties internes du corps 2 respectivement situées dans la troisième et la quatrième zone du corps 2, c'est-à-dire les zones Z2 et Z4. Cette troisième et cette quatrième partie primaire sont symétriques l'une de l'autre par rapport au plan S1, et chacune d'elles est symétrique par rapport au plan S2.

Il est évident que ces quatre parties primaires sont soumises aux mêmes contraintes, soit d'expansion, soit de contraction, en réponse au champ électrique F.

Le fait que deux de ces parties primaires soient des parties externes du corps 2, symétriques l'une de l'autre par rapport au plan S2 et symétriques, chacune, par rapport au plan S1, et que les deux autres parties primaires soient des parties internes de ce corps 2, symétriques l'une de l'autre par rapport au plan S1 et symétriques, chacune, par rapport au plan S2, a pour effet que, lorsque la fréquence de la tension primaire Up est au moins sensiblement égale à une fréquence fr déterminée, qui sera précisée plus loin, les contraintes alternatives mentionnées ci-dessus provoquent une vibration du corps 2 dans un mode particulier qui sera qualifié de bi-elliptique pour une raison qui sera rendue. évidente également plus loin. Comme on le verra, ce mode bi-elliptique, dont la fréquence fr est la fréquence de résonance fondamentale, est tout à fait différent des modes de vibration du corps des transformateurs connus décrits ci-dessus, dans lesquels la forme générale de ces corps reste inchangée.

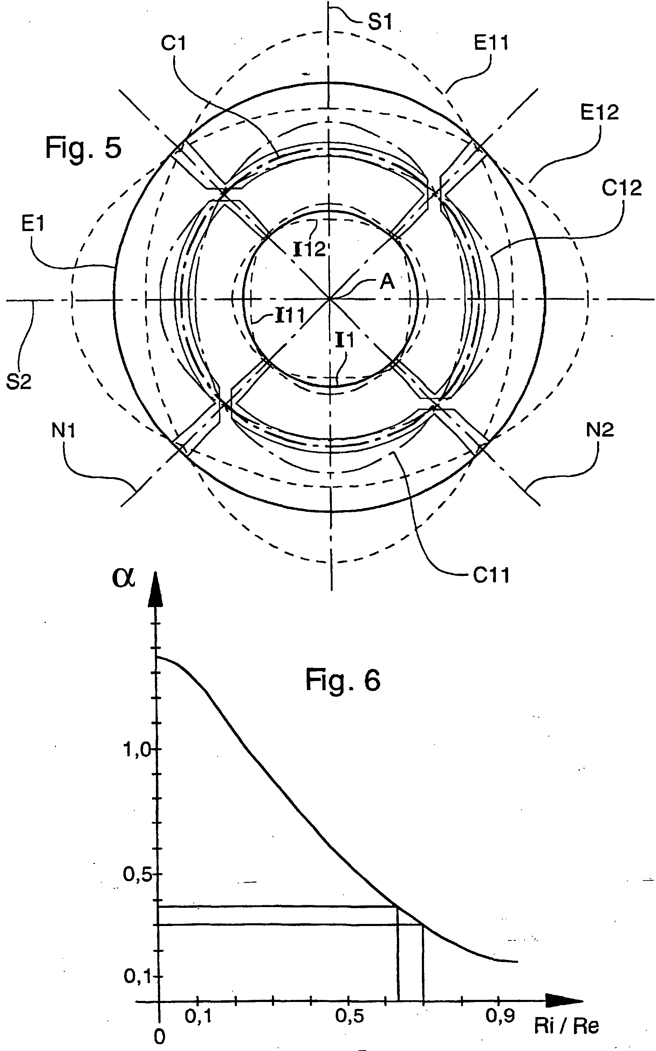

Ce mode de vibration bi-elliptique sera décrit en détail ci-après à l'aide de la figure 5.

Il faut noter que seule la face 3 du corps 2 est visible dans la figure 5. En outre, les électrodes 5 à 12, les pistes conductrices 13 à 16 et les tiges de connexion 29 à 32 disposées sur cette face 3 n'ont pas été représentées dans la figure 5 pour ne pas la charger inutilement.

Dans la figure 5, les contours extérieur E1 et intérieur I1 de la face 3 ont été représentés en traits pleins dans la forme circulaire qu'ils ont lorsque le corps 2 ne vibre pas. De même, le cercle moyen C1 a été représenté en traits mixtes.

Il faut aussi noter que, pour simplifier la description qui va suivre, on appellera grand axe et petit axe des divers cylindres elliptiques qui seront mentionnés ce qui est en fait le grand axe, respectivement le petit axe, des ellipses formées par l'intersection de ces cylindres elliptiques avec l'un quelconque des plans perpendiculaires à l'axe A.

Le mode de vibration particulier du corps 2 mentionné ci-dessus est qualifié de bi-elliptique car, lorsque ce corps 2 vibre dans ce mode, il prend alternativement la forme d'un premier et d'un deuxième anneau elliptique. Ces anneaux elliptiques sont en outre variables comme cela sera montré plus loin.

En d'autres termes, lorsque le corps 2 vibre dans ce mode bi-elliptique, sa paroi extérieure E prend alternativement la forme d'un premier et d'un deuxième cylindre elliptique, qui seront qualifiés d'extérieurs, alors que la paroi intérieure I de ce corps 2 prend respectivement la forme d'un autre premier et d'un autre deuxième cylindre elliptique, qui seront qualifiés d'intérieurs.

Plus précisément, les grands axes du premier et du deuxième cylindre elliptique extérieur sont respectivement situés dans les plans S1 et S2, de même que les grands axes du premier et du deuxième cylindre elliptique intérieur. En outre, les petits axes du premier et du deuxième cylindre elliptique extérieur sont respectivement situés dans les plans S2 et S1, ainsi que les petits axes du premier et du deuxième cylindre elliptique intérieur. Tous ces grands axes et tous ces petits axes sont évidemment perpendiculaires à l'axe A.

En outre, lorsque la paroi extérieure E et la paroi intérieure I du corps 2 ont la forme de l'un des cylindres elliptiques extérieur et, respectivement, intérieur mentionnés ci-dessus, la longueur du grand axe de chacun de ces cylindres elliptiques varie régulièrement en augmentant depuis une valeur minimale jusqu'à une valeur maximale puis en diminuant jusqu'à sa valeur minimale. Les parois extérieure E et intérieure I prennent ensuite la forme de l'autre cylindre elliptique extérieur et, respectivement, intérieur après avoir passé par la forme de cylindre circulaire qu'elles ont en l'absence de vibration du corps 2.

Simultanément, la longueur du petit axe de chacun de ces cylindres elliptiques varie également régulièrement mais en sens inverse, cette longueur diminuant depuis une valeur maximale jusqu'à une valeur minimale puis augmentant jusqu'à sa valeur maximale, de manière que le volume du corps 2 reste constant.

Il est évident que lorsque le corps 2 vibre de la manière qui vient d'être décrite, le cylindre moyen C prend également alternativement la forme d'un premier et d'un deuxième cylindre elliptique, qui seront qualifiés de moyens, dont les grands axes sont aussi respectivement situés dans les plans S1 et S2, et dont les petits axes sont aussi respectivement situés dans les plans S2 et S1. En outre, la longueur des grands axes et des petits axes de ces cylindres elliptiques moyens varie de manière analogue à celle qui a été décrite ci-dessus.

Il faut encore noter que la longueur minimale du grand axe de chacun des cylindres elliptiques extérieurs, intérieurs et moyens mentionnés ci-dessus, et la longueur maximale de leur petit axe est évidemment respectivement égale au diamètre de la paroi extérieure E, de la paroi intérieure I et du cylindre moyen C en l'absence de vibration. La longueur maximale de ces grands axes et la longueur minimale de ces petits axes dépend de divers facteurs tels que, par exemple, les caractéristiques mécaniques et électromécaniques du matériau-du corps 2, et la fréquence et l'amplitude de la tension, primaire Up. L'homme du métier comprendra facilement que, toutes autres choses étant égales, cette longueur maximale de ces grands axes et cette longueur minimale de ces petits axes ont respectivement leur plus grande et leur plus petite valeur lorsque la fréquence de la tension Up est égale à la fréquence de résonance fondamentale fr du mode de résonance bi-elliptique du corps 2.

La figure 5 montre des exemples des diverses ellipses formées par l'intersection des cylindres elliptiques décrits ci-dessus avec le plan de la face 3 du corps 2. Ces ellipses seront qualifiées de la même manière que les cylindres elliptiques qui les forment.

Ainsi, dans la figure 5, un exemple d'une première ellipse extérieure et un exemple d'une deuxième ellipse extérieure ont été représentés en traits interrompus et respectivement désignés par les références E11 et E12.

De même, les exemples correspondant de première ellipse intérieure et de deuxième ellipse intérieure ont été représentés, également en traits interrompus, et respectivement désignés par les références I11 et I12.

Enfin, les exemples correspondants de première ellipse moyenne et de deuxième ellipse moyenne ont été représentés en traits mixtes et respectivement désignés par les références C11 et C12.

Il faut noter que les diverses ellipses représentées dans la figure 5 l'ont été de manière très exagérée, la différence entre les longueurs maximale et minimale de leurs grands axes et de leurs petits axes étant en pratique généralement inférieure à un millième de ces longueurs.

La vibration du corps 2 dans le mode bi-elliptique décrit ci-dessus provoque évidemment l'application de contraintes mécaniques alternatives de contraction et d'expansion, dans les directions perpendiculaires à l'axe A, des quatre parties du corps 2 qui sont respectivement situées entre les paires d'électrodes 6 et 18, 8 et 20, 9 et 21 et 11 et 23. Ces quatre parties seront qualifiées de secondaires dans la suite de cette description.

De manière bien connue, le couplage électromécanique 31, déjà mentionné, entre ces contraintes alternatives et la polarisation P du matériau du corps 2 provoque la formation d'un champ électrique F' dans ces parties secondaires. Ce champ F' est également alternatif, et il a une direction parallèle à celle de cette polarisation P et un sens qui est alternativement le même que celui de cette polarisation P et le sens inverse de ce dernier. Toujours de manière bien connue, ce champ F' provoque l'apparition de la tension alternative secondaire Us entre les paires d'électrodes, énumérées ci-dessus, qui délimitent les parties secondaires du corps 2, et donc entre les bornes BS1 et BS2 du transformateur 1.

Dans l'exemple décrit ci-dessus, une première et une deuxième des quatre parties secondaires, c'est-à-dire celles qui sont situées entre les électrodes 9 et 21 et, respectivement, 11 et 23, sont des parties internes du corps 2 et sont respectivement situées dans la première et dans la deuxième des zones définies ci-dessus, c'est-à-dire les zones Z1 et Z3, où se trouvent aussi la première et, respectivement, la deuxième partie primaire également définies ci-dessus. Cette première et cette deuxième partie secondaire sont aussi symétriques l'une de l'autre par rapport au plan S2, et chacune d'elles est symétrique par rapport au plan S1.

De même, la troisième et la quatrième partie secondaire, c'est-à-dire celles qui sont situées entre les électrodes 6 et 18 et, respectivement, 8 et 20 sont des parties externes du corps 2 et sont respectivement situées dans la troisième et dans la quatrième des zones définies ci-dessus, c'est-à-dire les zones Z2 et Z4, où se trouvent aussi la troisième et, respectivement, la quatrième partie primaire également définies ci-dessus. Cette troisième et cette quatrième partie secondaire sont aussi symétriques l'une de l'autre par rapport au plan S1, et chacune d'elles est symétrique par rapport au plan S2.

Cependant, le matériau du corps 2 est isotrope dans toutes les directions perpendiculaires à l'axe A. Il en découle que les parties du corps 2 qui ont été choisies, dans le présent exemple, pour être des parties primaires auraient pu tout aussi bien être choisies pour être des parties secondaires, et vice-versa.

De même, les électrodes qui ont été choisies pour être des électrodes primaires auraient évidemment pu être choisies pour être des électrodes secondaires, et vice-versa.

D'une manière générale, on peut donc dire que chacune des faces 3 et 4 du corps 2 du transformateur 1 comporte une première et une deuxième électrode primaire qui sont des électrodes externes symétriques l'une de l'autre par rapport à un premier des plans S1 et S2 et symétriques, chacune, par rapport au deuxième de ces plans S2 et S2.

Chacune de ces faces 3 et 4 comporte encore une troisième et une quatrième électrode primaire qui sont des électrodes internes symétriques l'une de l'autre par rapport au deuxième des plans définis ci-dessus et symétriques, chacune, par rapport au premier de ces plans.

De plus, chacune des faces 3 et 4 comporte une première et une deuxième électrode secondaire qui sont des électrodes internes symétriques l'une de l'autre par rapport au premier des plans définis ci-dessus et symétriques, chacune, par rapport au deuxième de ces plans.

Enfin, chacune des faces 3 et 4 comporte une troisième et une quatrième électrode secondaire qui sont des électrodes externes symétriques l'une de l'autre par rapport au deuxième des plans définis ci-dessus et symétriques, chacune, par rapport au premier de ces plans.

Il faut noter que, lorsque le corps 2 vibre dans le mode bi-elliptique décrit ci-dessus, le premier cylindre elliptique moyen défini également ci-dessus coupe les plans N1 et N2 selon quatre droites parallèles à l'axe A dont la position est fixe quelle que soit l'amplitude de la vibration du corps 2 et qui sont également celles selon lesquelles le cylindre circulaire moyen coupe les plans N1 et N2. En outre, le deuxième cylindre elliptique moyen coupe ces plans N1 et N2 selon les mêmes quatre droites.

Ces quatre droites sont donc des droites nodales de la vibration bi-elliptiques du corps 2, et les points où elles coupent les plans des faces 3 et 4 du corps 2 sont des points nodaux de cette vibration. C'est la raison pour laquelle les tiges de connexion 29 à 32 sont fixées de préférence en ces points comme cela a déjà été mentionné.

Des considérations théoriques qui ne seront pas reproduites ici montrent que la fréquence de résonance fondamentale fr du mode de vibration bi-elliptique d'un anneau tel que le corps 2 est donnée par l'équation :

$$fr = \frac{\alpha}{2\Pi \cdot Re} \cdot \sqrt{\frac{E}{\rho \cdot (1-\upsilon^2)}} \qquad (1)$$

dans laquelle :

- Re est le rayon extérieur du corps 2 en l'absence de vibration du corps 2;
- $\alpha$ est un coefficient déterminé analytiquement qui dépend du rapport Ri/Re entre le rayon intérieur Ri et le rayon extérieur Re du corps 2 également en l'absence de vibration de ce dernier;
- E est le module de Young du matériau du corps 2;
- $\rho$ est la masse spécifique du matériau du corps 2; et
- $\upsilon$ est le coefficient de Poisson du matériau du corps 2.

La figure 6 illustre la variation du coefficient $\alpha$ mentionné ci-dessus en fonction du rapport Ri/Re entre le rayon intérieur Ri et le rayon extérieur Re du corps 2. On voit que ce coefficient $\alpha$ varie, dans le cas présent, de 1,37 environ pour un rapport Ri/Re égal à zéro, c'est-à-dire pour un disque plein, à 0,17 environ pour un rapport Ri/Re égal à 0,9.

Si l'on choisit d'utiliser comme matériau du corps 2 la céramique communément appelée PZT (titanozirconate de plomb) qui est bien connue et couramment utilisée, ou a :

- E = 67 · 10⁹ Pascals;
- $\rho$ = 7,5 · 10³ kgm⁻³; et
- $\upsilon$ = 0,3.

En outre, si l'on choisit arbitrairement pour les rayons extérieur Re et intérieur Ri du corps 2 des valeurs égales par exemple à 8 mm et, respectivement, 5 mm, et donc un rapport Ri/Re égal à 0,625, la figure 6 montre que le coefficient $\alpha$ a une valeur de 0,38 environ.

Dans ces conditions, l'équation (1) ci-dessus donne :

$$fr = 23,68 \text{ kHz}$$

Si l'on désire que la fréquence de résonance fr ait une valeur déterminée, par exemple 25 kHz, et que le rayon extérieur Re soit égal, toujours par exemple, à 6 mm, l'équation (1) ci-dessus montre que, pour le même matériau que dans l'exemple précédent, le coefficient $\alpha$ doit être égal à 0,30. Le rapport Ri/Re doit donc être égal à 0,7 selon la figure 6, ce qui donne, pour le rayon intérieur Ri de ce corps 2, une valeur de 4,2 mm.

Les considérations théoriques mentionnées ci-dessus montrent également que lorsque le secondaire du transformateur 1 n'est relié à aucune charge et que la fréquence de la tension Up est égale à la fréquence de résonance fondamentale donnée par l'équation (1) ci-dessus, le rapport entre la tension secondaire Us et la tension primaire Up, c'est-à-dire le rapport de transformation à vide T du transformateur 1, est donné par l'équation suivante :

$$T = \frac{Us}{Up} = \frac{Q \cdot k^2}{1 - k^2} \qquad (2)$$

dans laquelle :

- Q est le facteur de surtension, ou facteur de qualité, du corps 2 et dépend des caractéristiques mécaniques du matériau de ce corps 2; et
- k est le coefficient de couplage électromécanique effectif du matériau du corps 2 dans le mode de couplage 31 utilisé dans le présent exemple et déjà mentionné.

On voit que ce rapport de transformation ne dépend que des caractéristiques du matériau du corps 2 et pas des dimensions de ce dernier.

Lorsque le matériau du corps 2 est celui qui a été mentionné dans les exemples ci-dessus, on a :

- Q = 800; et
- k = 0,2.

Dans ce cas, l'équation (2) ci-dessus donne :

$$T = 33,3$$

Il faut noter que l'épaisseur du corps 2, c'est-à-dire sa dimension dans la direction parallèle à l'axe A, n'intervient pas dans les équations (1) et (2) ci-dessus, de sorte que la fréquence de résonance fr et le rapport de transformation T sont indépendants de cette épaisseur. L'homme du métier comprendra que la résistance mécanique du corps 2, qui dépend évidemment de son épaisseur, doit cependant être suffisante pour qu'il supporte sans dommage les contraintes mécaniques auxquelles il est soumis pendant sa vibration.

En outre, l'homme du métier comprendra aussi que l'épaisseur du corps 2 influence la valeur des impédances primaire et secondaire du transformateur 1.

Les considérations théoriques évoquées ci-dessus, qui permettent également de calculer la valeur des contraintes mécaniques subies par le corps 2 pendant sa vibration, montrent que ce corps 2 peut généralement avoir une épaisseur de l'ordre de 1 mm, voire même inférieure à 1 mm, selon le matériau dont il est fait, sans que sa résistance mécanique ne devienne insuffisante. La valeur exacte de cette épaisseur est évidemment déterminée de manière que les impédances primaire et secondaire aient les valeurs désirées.

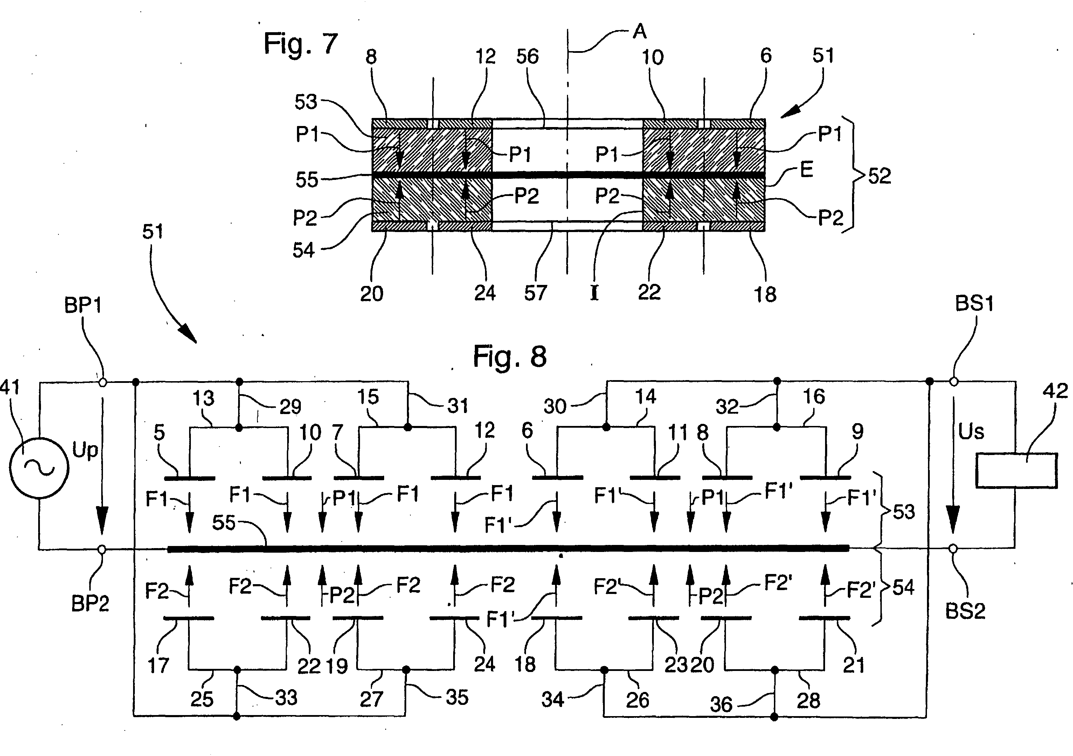

La figure 7 illustre une autre forme d'exécution du transformateur selon la présente invention, qui est désigné dans ce cas par la référence générale 51.

La transformateur 51 comporte un corps 52 comprenant deux pièces en forme d'anneaux circulaires 53 et 54 identiques l'un à l'autre et ayant un axe de symétrie circulaire également désigné par la référence A.

Les anneaux 53 et 54 sont en un matériau piézo-électrique qui peut aussi être n'importe lequel des matériaux piézo-électriques bien connus des spécialistes, et ils sont fixés l'un à l'autre par l'intermédiaire d'une couche métallique mince d'un matériau électriquement conducteur qui recouvre la totalité des surfaces des anneaux 53 et 54 en regard l'une de l'autre. On verra plus loin que cette couche métallique constitue une électrode commune qui sera désignée par la référence 55.

Le matériau piézo-électrique des anneaux 53 et 54 est polarisé uniformément dans une direction parallèle à l'axe A, mais le sens de polarisation du matériau de l'anneau 53 est opposé au sens de polarisation du matériau de l'anneau 54. Dans l'exemple représenté à la figure 7, ces polarisations, qui sont symbolisées par les flèches désignées respectivement par les références P1 et P2, sont dirigées depuis les faces extérieures 56 et 57 des anneaux 53 et 54 vers l'électrode 55. L'homme du métier comprendra facilement que ces polarisations P1 et P2 peuvent tout aussi bien être dirigées dans les sens inverses.

Le transformateur 51 comporte également des électrodes disposées sur les faces extérieures 56 et 57 des anneaux 53 et 54, des pistes conductrices reliant ces électrodes deux à deux, et des tiges de connexion destinées à permettre de relier ces électrodes à une source de tension alternative primaire et au dispositif que la tension alternative secondaire est destinée à alimenter. Ces composants du transformateur 51 ne seront pas décrits à nouveau ici car ils sont identiques aux composants correspondants du transformateur 1 représentés aux figures 1 et 3 et seront désignés par les mêmes références que ces derniers.

La figure 8 illustre une manière de faire fonctionner le transformateur 51 qui vient d'être décrit.

Dans ce cas, les tiges de connexion 29 et 31 sont reliées entre elles et à la première borne primaire BP1, comme dans le cas du transformateur 1 illustré par la figure 4. En outre, les tiges de connexion 33 et 35 sont également reliées entre elles, comme dans le cas de la figure 4, mais elles sont par contre également reliées à la première borne primaire BP1.

De même, les tiges de connexion 30 et 32 sont reliées entre elles et à la première borne secondaire BS1, comme dans le cas de la figure 4. En outre, les tiges de connexion 34 et 36 sont reliées entre elles comme dans ce même cas de la figure 4, mais elles sont par contre également reliées à la première borne secondaire BS1.

Enfin, l'électrode commune 55 est reliée à la deuxième borne primaire BP2 et à la deuxième borne secondaire BS2.

La source destinée à fournir la tension primaire, également désignée par Up, et le dispositif auquel le transformateur 51 doit fournir la tension secondaire, également désignée par Us, ont aussi été représentés à la figure 8 avec les mêmes références 41 et, respectivement, 42 que dans le cas de la figure 4.

Par analogie avec le transformateur 1 décrit ci-dessus, on appellera parties primaires de l'anneau 53 les parties de ce dernier qui sont situées entre l'électrode commune 55 et les électrodes 5, 7, 10 et 12. De même, on appellera parties primaires de l'anneau 54 les parties de ce dernier qui sont situées entre l'électrode commune 55 et les électrodes 17, 19, 22 et 24. En outre, on appellera parties primaires du corps 52 les parties de ce dernier qui sont formées par l'une des parties primaires de l'anneau 53 et par la partie primaire de l'anneau 54 située en regard de cette dernière. Ces parties primaires du corps 52 sont donc celles qui sont respectivement situées entre les paires d'électrodes 5 et 17, 7 et 19, 10 et 22, et 12 et 24. Ces électrodes 5, 7, 10, 12, 17, 19, 22 et 24 seront qualifiées de primaires.

Toujours par analogie avec le transformateur 1, on appellera parties secondaires de l'anneau 53 les parties de ce dernier qui sont situées entre l'électrode commune 55 et les électrodes 6, 8, 9 et 11. De même, on appellera parties secondaires de l'anneau 54 les parties de ce dernier qui sont situées entre l'électrode commune 55 et les électrodes 18, 20, 21 et 23. En outre, on appellera parties secondaires du corps 52 les parties de ce dernier qui sont formées par l'une des parties secondaires de l'anneau 53 et par la partie secondaire de l'anneau 54 située en regard de cette dernière. Ces parties secondaires du corps 52 sont donc celles qui sont respectivement situées entre les paires d'électrodes 6 et 18, 8 et 20, 9 et 21, et 11 et 23. Ces électrodes 6, 8, 9, 11, 18, 20, 21 et 23 seront qualifiées de secondaires.

On voit que les parties primaires et les parties secondaires du corps 52 sont disposées les unes par rapport aux autres exactement comme celles du corps 2 du transformateur 1. De même, sur chacune des faces 56 et 57 du corps 52, les électrodes primaires et les électrodes secondaires sont disposées les unes par rapport aux autres exactement comme celles qui sont situées sur les faces 3 et 4 du corps 2 du transformateur 1.

On voit également que les champs électriques F1 et F2 respectivement produits dans les parties primaires de l'anneau 53 et de l'anneau 54 en réponse à la tension primaire Up ont toujours simultanément soit le même sens que les polarisations P1 et P2 respectives soit le sens inverse de celui de ces polarisations.

Le couplage électromécanique transverse du champ F1 avec le matériau de l'anneau 53 et du champ F2 avec le matériau de l'anneau 54 entraîne donc l'application de contraintes mécaniques identiques à toutes les parties primaires de ces anneaux 53 et 54, et ces contraintes provoquent alternativement une contraction et une expansion de ces parties primaires dans toutes les directions perpendiculaires à l'axe A.

Ces parties primaires des anneaux 53 et 54 formant deux à deux les parties primaires du corps 52 comme cela a été défini ci-dessus, il découle de ce qui précède que, lorsque la fréquence de la tension primaire Up est au moins sensiblement égale à la fréquence fr définie ci-dessus par l'équation (1), le corps 52 du transformateur 51 vibre aussi dans le mode bi-elliptique décrit également ci-dessus dans le cas du transformateur 1. Ce mode de vibration bi-elliptique ne sera donc pas décrit à nouveau ici.

De même, lorsque le corps 52 du transformateur 51 vibre dans ce mode bi-elliptique, les parties secondaires des anneaux 53 et 54 sont toujours soumises aux mêmes contraintes mécaniques, de sorte que les champs électriques F1' et F2' produits dans ces parties secondaires ont toujours soit le même sens que les polarisations respectives P1 et P2, soit le sens inverse de celui de ces polarisations P1 et P2.

Les tensions qui sont produites en réponse à ces champs F1' et F2' entre l'électrode commune 55 et les électrodes 6, 8, 9 et 11 d'une part et les électrodes 18, 20, 21 et 23 d'autre part ont donc toujours la même polarité et constituent ensemble, la tension secondaire Us.

Le rapport entre les tensions Us et Up, c'est-à-dire le rapport de transformation T du transformateur 51, est aussi donné par l'équation (2) mentionnée ci-dessus, et il est donc identique à celui du transformateur 1 décrit ci-dessus.

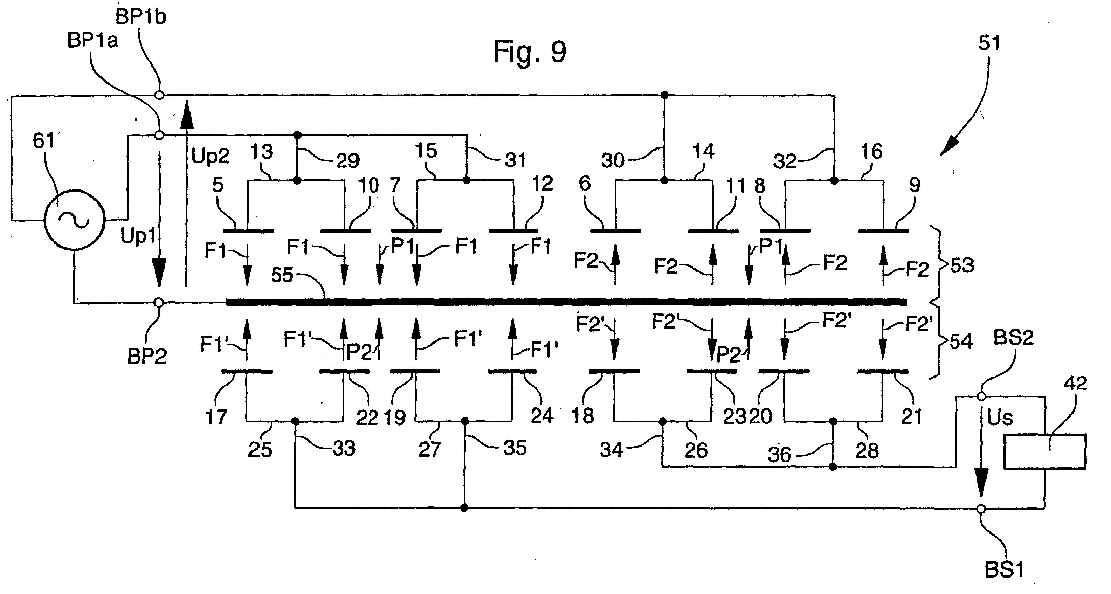

La figure 9 illustre une autre manière de faire fonctionner le transformateur 51 décrit à l'aide de la figure 7.

Dans ce cas, les tiges de connexion 29 et 31 sont reliées l'une à l'autre et à une première borne primaire BP1a, alors que les tiges de connexion 30 et 32 sont reliées l'une à l'autre et à une deuxième borne primaire BP1b.

L'électrode commune 55 est reliée à une troisième borne primaire BP2.

Toujours dans ce cas, les tiges de connexion 33 et 35 sont reliées entre elles et à une première borne secondaire BS1, alors que les tiges de connexion 34 et 36 sont reliées entre elles et à une deuxième borne secondaire BS2.

Dans ce cas, le transformateur 51 est alimenté par une source, désignée par 61, qui fournit deux tensions alternatives Up1 et Up2 constituant ensemble la tension primaire Up, qui ont la même fréquence et la même amplitude, mais qui sont déphasées de 180° l'une par rapport à l'autre. En d'autres termes, ces tensions Up1 et Up2 ont des polarités qui sont toujours inverses l'une de l'autre. Cette source 61 ne sera pas décrite plus en détail, car sa réalisation est à la portée d'un spécialiste en la matière.

La source 61 est reliée aux bornes BP1a, BP1b et BP2 de manière que la tension Up1 soit appliquée entre la borne BP1a et la borne BP2, et que la tension Up2 soit appliquée entre la borne BP1b et la même borne BP2.

On voit que, dans ce cas, les parties primaires du corps 52 forment deux groupes, le premier de ces groupes étant constitué par les parties primaires situées entre l'électrode commune 55 et les électrodes 5, 7, 10 et 12, et le deuxième de ces groupes étant constitué par les parties primaires situées entre cette électrode commune 55 et les électrodes 6, 8, 9 et 11.

De même, les parties secondaires du corps 52 forment aussi deux groupes dont le premier est constitué par les parties secondaires situées entre l'électrode commune 55 et les électrodes 17, 19, 22 et 24, et dont le deuxième est constitué par les parties secondaires situées entre cette électrode commune 55 et les électrodes 18, 20, 21 et 23.

Dans ce cas, toutes les parties primaires et toutes les parties secondaires appartiennent donc respectivement à l'anneau 53 et à l'anneau 54.

On voit encore que dans les parties primaires du premier groupe et dans les parties primaires du deuxième groupe, les champs électriques respectifs F1 et F2 produits en réponse aux tensions Up1 et Up2 ont toujours des sens opposés l'un à l'autre, chacun de ces champs F1 et F2 ayant en outre soit le même sens que la polarisation P1 du matériau de l'anneau 53 soit le sens inverse de celui de cette polarisation P1.

Il en découle que lorsque les parties primaires du premier groupe sont soumises, par exemple, à une contrainte mécanique d'expansion, les parties primaires du deuxième groupe sont soumises à une contrainte mécanique de contraction, et vice-versa.

On voit également que, dans chacune des zones Z1 et Z3, les parties externes, c'est-à-dire celles qui sont respectivement situées en regard des électrodes 5 et 7, appartiennent au premier groupe de parties primaires, alors que les parties internes, c'est-à-dire celles qui sont respectivement situées en regard des électrodes 9 et 11, appartiennent au deuxième groupe de parties primaires.

De même, dans chacune des autres zones Z2 et Z4, les parties externes, c'est-à-dire celles qui sont respectivement situées en regard des électrodes 6 et 8, appartiennent au deuxième groupe de parties primaires, alors que les parties internes, c'est-à-dire celles qui sont respectivement situées en regard des électrodes 10 et 12, appartiennent au premier groupe de parties primaires.

Il découle de ce qui précède que, d'une manière générale, lorsque les parties externes situées dans deux des zones Z1 à Z4 diamétralement opposées sont soumises, par exemple, à une contrainte de contraction, les parties internes situées dans les mêmes zones sont soumises à une contrainte d'expansion. En outre, les parties externes situées dans les deux autres zones sont simultanément soumises à une contrainte d'expansion, alors que les parties internes situées dans ces dernières zones sont soumises à une contrainte de contraction.

Cette répartition des contraintes dans les diverses parties primaires du corps 52 a pour effet que ce dernier vibre également dans le mode bi-elliptique décrit ci-dessus lorsque la fréquence des tensions Up1 et Up2 est au moins sensiblement égale à la fréquence fr définie ci-dessus par l'équation (1).

De même, lorsque le corps 52 du transformateur 51 vibre dans ce mode bi-elliptique et que les parties secondaires du premier groupe sont soumises, en réponse à cette vibration, à une contrainte mécanique d'expansion, par exemple, les parties secondaires du deuxième groupe sont soumises à une contrainte mécanique de contraction, et vice-versa.

Il en découle que les champs électriques F1' et F2' respectivement produits dans ces parties secondaires du premier groupe et dans ces parties secondaires du deuxième groupe ont toujours des sens opposés. En outre, les tensions produites en réponse à ces champs F1' et F2' entre l'électrode commune 55 et les électrodes 17, 19, 22 et 24 d'une part, et les électrodes 18, 20, 21 et 23 d'autre part, qui ont évidemment la même fréquence et la même amplitude, ont toujours des polarités inverses. l'une de l'autre.

Lorsque les tiges de connexion 33 à 36 sont connectées de la manière décrite ci-dessus et représentée à la figure 9, ces deux tensions s'additionnent donc pour former la tension secondaire Us produite par le transformateur 51.

Dans ce cas, le rapport de transformation T du transformateur est également donné par l'équation (2) mentionnée ci-dessus.

On voit que, pour un encombrement comparable, la fréquence de résonance fondamentale du mode de vibration bi-elliptique du corps d'un transformateur selon la présente invention est très nettement plus basse que celle des modes de vibration du corps des transformateurs connus décrits ci-dessus.

Un transformateur selon la présente invention peut donc fournir une tension secondaire ayant une fréquence également nettement plus basse que celle qui est fournie par un transformateur connu.

En outre, le rapport de transformation d'un transformateur selon la présente invention est du même ordre que celui d'un transformateur connu, voire même supérieur à ce dernier.

Un transformateur selon la présente invention est donc particulièrement bien adapté à être utilisé dans un dispositif tel qu'une montre-bracelet où la place disponible est limitée, dans tous les cas où il est nécessaire d'obtenir une tension alternative relativement élevée ayant une fréquence relativement basse.

En outre, le fait que le matériau piézo-électrique dont est fait le corps du transformateur selon la présente invention, ou chacune des pièces formant ce corps, est polarisé uniformément dans la direction perpendiculaire à ses faces simplifie la fabrication de ce corps et diminue le prix de revient de ce transformateur.

Il est évident que de nombreuses modifications peuvent être apportées au transformateur selon la présente invention dont des formes d'exécution ont été décrites ci-dessus sans pour autant sortir du cadre de l'invention telle que revendiquée.

Ainsi, par exemple, il est possible de donner au corps d'un transformateur selon la présente invention la forme d'un disque plein, sans ouverture centrale, ce disque pouvant être réalisé d'une seule pièce, comme le corps 2 du transformateur 1 des figures 1 à 3, ou être formé de deux pièces identiques comme le corps 52 du transformateur 51 de la figure 7.

De même, les diverses électrodes disposées sur le corps du transformateur selon la présente invention peuvent avoir des formes différentes de celle qu'elles ont dans les exemples décrits, et leurs liaisons peuvent être réalisées différemment.

L'homme du métier verra aussi qu'il n'est pas obligatoire de prévoir autant d'électrodes secondaires que dans les exemples décrits ci-dessus. A la limite, il serait suffisant de ne prévoir qu'une seule paire d'électrodes secondaires, par exemple les électrodes 6 et 18, ou 11 et 23 des figures 4 et 8, ou les électrodes 17 et 18, ou 21 et 22 de la figure 9.

**Revendications**

1. Transformateur piézo-électrique (1; 51) comportant :

   - un corps (2; 52) en un matériau piézo-électrique ayant une première (3; 56) et une deuxième face (4; 57) ainsi qu'une surface latérale externe (E);
   - une pluralité d'électrodes primaires (5, 7, 10, 12, 17, 19, 22, 24; 5 à 12) disposées sur ledit corps (2; 52) pour exciter une vibration dudit corps (2; 52) en réponse à une tension primaire alternative (Up; Up1, Up2); et
   - une pluralité d'électrodes secondaires (6, 8, 9, 11, 18, 20, 21, 23; 17 à 24) disposées sur ledit corps (2; 52) pour produire une tension secondaire (Us) en réponse à ladite vibration;

   ladite surface externe (E) ayant, en l'absence de ladite vibration, la forme d'un premier cylindre circulaire ayant un axe de symétrie circulaire (A) et lesdites faces (3; 4; 56, 57) ayant chacune une partie externe située du côté de ladite surface latérale externe (E) et une partie interne entourée par ladite partie externe,

**caractérisé par le fait que** lesdites électrodes primaires (5, 7, 10, 12, 17, 19, 22, 24; 5 à 12) sont disposées de manière que, lorsque ladite tension primaire (Up; Up1, Up2) a une fréquence au moins sensiblement égale à une fréquence déterminée (fr), ladite surface latérale externe (E) prend alternativement la forme d'un premier cylindre elliptique et la forme d'un deuxième cylindre elliptique, ledit premier cylindre elliptique ayant un grand axe et un petit axe perpendiculaires audit axe de symétrie circulaire (A) et respectivement situés dans une premier plan de symétrie (S1) comprenant ledit axe de symétrie circulaire (A) et dans un deuxième plan de symétrie (S2) perpendiculaire audit premier plan de symétrie (S1) et comprenant également ledit axe de symétrie circulaire (A), ledit deuxième cylindre elliptique ayant un grand axe et un petit axe perpendiculaires audit axe de symétrie circulaire (A) et respectivement situés dans ledit deuxième plan de symétrie (S2) et dans ledit premier plan de symétrie (S1), et, lorsque ladite surface latérale externe (E) a la forme de l'un desdits premier et deuxième cylindres elliptiques, le grand axe respectif ayant une longueur qui varie régulièrement en augmentant depuis une valeur minimale égale au diamètre dudit cylindre circulaire jusqu'à une valeur maximale puis en diminuant depuis ladite valeur maximale jusqu'à ladite valeur minimale, ladite surface latérale externe (E) prenant ensuite la forme de l'autre desdits premier et deuxième cylindres elliptiques.

2. Transformateur piézo-électrique selon la revendication 1, **caractérisé par le fait que** ledit corps (2) est formé d'une seule pièce et que ledit matériau piézo-électrique est polarisé uniformément dans une direction parallèle audit axe de symétrie circulaire (A) et dans un sens allant de l'une (3) à l'autre (4) desdites première et deuxième faces (3, 4) dudit corps (2).

3. Transformateur piézo-électrique selon la revendication 1, **caractérisé par le fait que** ledit corps (52) comporte une première (53) et une deuxième pièce (54), que le matériau piézo-électrique de ladite première pièce (53) est polarisé uniformément dans une direction parallèle audit axe de symétrie circulaire (A) et dans un premier sens allant de l'une (56) à l'autre (57) desdites première et deuxième faces dudit corps (52), que le matériau de ladite deuxième pièce (54) est polarisé uniformément dans ladite direction parallèle audit axe de symétrie circulaire (A) et dans un deuxième sens opposé audit premier sens, et que ledit transformateur (51) comporte une électrode commune (55) disposée entre ladite première (53) et ladite deuxième pièce (54) dudit corps (52).

4. Transformateur piézo-électrique selon l'une des revendications 2 et 3, **caractérisé par le fait que** ladite pluralité d'électrodes primaires (5, 7, 10, 12, 17, 19, 22, 24, figures 4 et 8) comporte :

   - une première (5) et une deuxième électrode primaire (7) symétriques, chacune, par rapport audit premier plan de symétrie (S1), symétriques l'une de l'autre par rapport audit deuxième plan de symétrie (S2) et disposées toutes deux sur ladite partie externe de ladite première face (3; 56) dudit corps (2; 52);
   - une troisième (10) et une quatrième électrode primaire (12) symétriques, chacune, par rapport audit deuxième plan de symétrie (S2), symétriques l'une de l'autre par rapport audit premier plan de symétrie (S1) et disposées toutes deux sur ladite partie interne de ladite première face (3; 56) dudit corps; et
   - une cinquième (17), une sixième (19), une septième (22) et une huitième électrode primaire (24) toutes disposées sur ladite deuxième face (4; 57) dudit corps (2; 52) en regard de ladite première (5), de ladite deuxième (7), de ladite troisième (10) et, respectivement, de ladite quatrième électrode primaire (12).

5. Transformateur piézo-électrique selon la revendication 4, **caractérisé par le fait qu'**il comporte des moyens (13, 15, 25, 27, figures 4 et 8) pour relier électriquement ladite première (5) et ladite troisième électrode primaire (10), ladite deuxième (7) et ladite quatrième électrode primaire (12), ladite cinquième (17) et ladite septième électrode primaire (22), ainsi que ladite sixième (19) et ladite huitième électrode primaire (24).

6. Transformateur piézo-électrique selon la revendication 4, **caractérisé par le fait que** ladite pluralité d'électrodes secondaires (6, 8, 9, 11, 18, 20, 21, 23, figures 4 et 8) comporte au moins une première électrode secondaire (6) disposée sur ladite première face (3; 56) dudit corps (2; 52) entre ladite première (5) et ladite deuxième électrode primaire (7) et symétrique par rapport audit deuxième plan de symétrie (S2), et une deuxième électrode secondaire (18) disposée sur ladite deuxième face (4; 57) dudit corps (2; 52) en regard de ladite première électrode secondaire (6).

7. Transformateur piézo-électrique selon la revendication 6, **caractérisé par le fait que** ladite pluralité d'électrodes secondaires (6, 8, 9, 11, 18, 20, 21, 23, figures 4 et 8) comporte en outre :

- une troisième (8) et une quatrième électrode secondaire (20) disposées en regard l'une de l'autre sur ladite première (3; 56) et, respectivement, sur ladite deuxième face (4; 57) dudit corps (2; 52) et respectivement symétriques de ladite première (6) et de ladite deuxième électrode secondaire (18) par rapport audit premier plan de symétrie (S1);
- une cinquième (9) et une sixième électrode secondaire (21) disposées en regard l'une de l'autre sur ladite première (3; 56) et, respectivement, sur ladite deuxième face (4; 57) dudit corps (2; 52) et situées entre ladite troisième (10) et ladite quatrième électrode primaire (12) et, respectivement, entre ladite septième (22) et ladite huitième électrode primaire (24); et
- une septième (11) et une huitième électrode secondaire (23) disposées en regard l'une de l'autre sur ladite première (3; 56) et, respectivement, sur ladite deuxième face (4; 57) dudit corps (2; 52) et respectivement symétriques de ladite cinquième (9) et de ladite sixième électrode secondaire (21) par rapport audit deuxième plan de symétrie (S2).

8. Transformateur piézo-électrique selon la revendication 4, **caractérisé par le fait que** ladite pluralité d'électrodes secondaires (6, 8, 9, 11, 18, 20, 21, 23, figures 4 et 8) comporte au moins une première électrode secondaire (9) disposée sur ladite première face (3; 56) dudit corps (2; 52) entre ladite troisième (10) et ladite quatrième électrode primaire (12) et symétrique par rapport audit premier plan de symétrie (S1), et une deuxième électrode secondaire (21) disposée sur ladite deuxième face (4; 57) dudit corps (2; 52) en regard de ladite première électrode secondaire (9).

9. Transformateur piézo-électrique selon la revendication 3, **caractérisé par le fait que** ladite pluralité d'électrodes primaires (5 à 12) comporte :

- une première (5) et une deuxième électrode primaire (7) symétriques, chacune, par rapport audit premier plan de symétrie (S1), symétriques l'une de l'autre par rapport audit deuxième plan de symétrie (S2) et disposées toutes deux sur ladite partie externe de ladite première face (56) dudit corps (52);
- une troisième (10) et une quatrième électrode primaire (12) symétriques, chacune, par rapport audit deuxième plan de symétrie (S2), symétriques l'une de l'autre par rapport audit premier plan de symétrie (S1) et disposées toutes deux sur ladite partie interne de ladite première face (56) dudit corps (52);
- une cinquième électrode primaire (6) symétrique par rapport audit deuxième plan de symétrie (S2) et disposée entre ladite première (5) et ladite deuxième électrode primaire (7);
- une sixième électrode primaire (8) symétrique de ladite cinquième électrode primaire (6) par rapport audit premier plan de symétrie (S1);
- une septième électrode primaire (9) symétrique par rapport audit premier plan de symétrie (S1) et disposée entre ladite troisième (10) et ladite quatrième électrode primaire (12); et
- une huitième électrode primaire (11) symétrique de ladite septième électrode primaire (9) par rapport audit deuxième plan de symétrie (S2).

10. Transformateur piézo-électrique selon la revendication 9, **caractérisé par le fait qu'**il comporte des moyens (13 à 16, figure 9) pour relier électriquement ladite première (5) et ladite troisième électrode primaire (10), ladite deuxième (7) et ladite quatrième électrode primaire (12), ladite cinquième (6) et ladite huitième électrode primaire (11), ainsi que ladite sixième (8) et ladite septième électrode primaire (9).

11. Transformateur piézo-électrique selon la revendication 9, **caractérisé par le fait que** ladite pluralité d'électrodes secondaires (17 à 24, figure 9) comporte au moins une première (17, 19, 22, 24) et une deuxième électrode secondaire (18, 20, 21, 23, figure 9) disposées sur ladite deuxième face (57) dudit corps (52) en regard de l'une desdites première (5), deuxième (7), troisième (10) et quatrième électrode primaire (12) et, respectivement, en regard de l'une desdites cinquième (6), sixième (8), septième (9) et huitième électrode primaire (11).

12. Transformateur piézo-électrique selon la revendication 9, **caractérisé par le fait que** ladite pluralité d'électrodes secondaires (17 à 24, figure 9) comporte huit électrodes secondaires (17 à 24, figure 9) disposées sur ladite deuxième face (57) dudit corps (52), chacune en regard de l'une desdites électrodes primaires (5 à 12, figure 9).

13. Transformateur piézo-électrique selon l'une des revendications 2 et 3, **caractérisé par le fait que** ledit corps (2; 52) a la forme générale d'un disque plein.

14. Transformateur piézo-électrique selon l'une des revendications 2 et 3, **caractérisé par le fait que** ledit corps (2; 52) a la forme générale d'un anneau comportant une surface latérale interne (I) ayant, en l'absence de ladite vibration, la forme d'un deuxième cylindre circulaire coaxial audit premier cylindre circulaire, ladite surface latérale interne (I) prenant alternativement la forme d'un troisième cylindre elliptique et la forme d'un quatrième cylindre elliptique lorsque ladite surface latérale externe (E) prend la forme dudit premier cylindre elliptique et, respectivement, la forme dudit deuxième cylindre elliptique, ledit troisième cylindre elliptique ayant un grand axe et un petit axe perpendiculaires audit axe de symétrie circulaire (A) et situés respectivement dans ledit premier (S1) et dans ledit deuxième plan de symétrie (S2), et ledit quatrième cylindre elliptique ayant un grand axe et un petit axe perpendiculaires audit axe de symétrie circulaire (A) et situés respectivement dans ledit deuxième (S2) et dans ledit premier plan de symétrie (S1).

**Patentansprüche**

1. Piezoelektrischer Transformator (1; 51), der umfaßt:

   - einen Körper (2; 52) aus einem piezoelektrischen Material, der eine erste Fläche (3; 56) und eine zweite Fläche (4; 57) sowie eine äußere seitliche Oberfläche (E) besitzt;
   - mehrere primäre Elektroden (5, 7, 10, 12, 17, 19, 22, 24; 5 bis 12), die auf dem Körper (2; 52) angeordnet sind, um in Reaktion auf eine primäre Wechselspannung (Up; Up1, Up2) eine Schwingung des Körpers (2; 52) zu erregen; und
   - mehrere sekundäre Elektroden (6, 8, 9, 11, 18, 20, 21, 23; 17 bis 24), die auf dem Körper (2; 52) angeordnet sind, um in Reaktion auf die Schwingung eine sekundäre Spannung (Us) zu erzeugen;

   wobei die äußere Oberfläche (E) dann, wenn keine Schwingung anliegt, die Form eines ersten kreisförmigen Zylinders mit einer Kreissymmetrieachse (A) hat und die Flächen (3; 4; 56, 57) jeweils einen äußeren Teil, der sich auf seiten der äußeren seitlichen Oberfläche (E) befindet, und einen inneren Teil, der von dem äußeren Teil umgeben ist, besitzt,

   **dadurch gekennzeichnet, daß** die primären Elektroden (5, 7, 10, 12, 17, 19, 22, 24; 5 bis 12) in der Weise angeordnet sind, daß die äußere seitliche Oberfläche (E) dann, wenn die primäre Spannung (Up; Up1, Up2) eine Frequenz besitzt, die wenigstens im wesentlichen gleich einer bestimmten Frequenz (fr) ist, abwechselnd die Form eines ersten elliptischen Zylinders und die Form eines zweiten elliptischen Zylinders annimmt, wobei der erste elliptische Zylinder eine große Achse und eine kleine Achse, die zu der Kreissymmetrieachse (A) senkrecht sind und in einer ersten Symmetrieebene (S1), die die Kreissymmetrieachse (A) enthält, bzw. in einer zweiten Symmetrieebene (S2), die zu der ersten Symmetrieebene (S1) senkrecht ist und ebenfalls die Kreissymmetrieachse (A) enthält, liegen, wobei der zweite elliptische Zylinder eine große Achse und eine kleine Achse besitzt, die zu der Kreissymmetrieachse (A) senkrecht sind und in der zweiten Symmetrieebene (S2) bzw. in der ersten Symmetrieebene (S1) liegen, wobei dann, wenn die äußere seitliche Oberfläche (E) die Form eines der ersten und zweiten elliptischen Zylinder hat, die entsprechende große Achse eine Länge besitzt, die sich regelmäßig ändert, indem sie ausgehend von einem Minimalwert, der gleich dem Durchmesser des kreisförmigen Zylinders ist, bis zu einem Maximalwert zunimmt und dann von dem Maximalwert bis zu dem Minimalwert abnimmt, wobei die äußere seitliche Oberfläche (E) anschließend die Form des anderen der ersten und zweiten elliptischen Zylinder annimmt.

2. Piezoelektrischer Transformator nach Anspruch 1, **dadurch gekennzeichnet, daß** der Körper (2) einteilig ausgebildet ist und daß das piezoelektrische Material in einer Richtung parallel zu der Kreissymmetrieachse (A) und in einer Richtung, die von der einen (3) zur anderen (4) der ersten und zweiten Flächen (3, 4) des Körpers (2) verläuft, gleichmäßig polarisiert ist.

3. Piezoelektrischer Transformator nach Anspruch 1, **dadurch gekennzeichnet, daß** der Körper (52) einen ersten Teil (53) und einen zweiten Teil (54) aufweist, daß das piezoelektrische Material des ersten Teils (53) in einer Richtung parallel zu der Kreissymmetrieachse (A) und in einem ersten Richtungssinn, der von der einen (56) zur anderen (57) der ersten und zweiten Flächen des Körpers (52) verläuft, gleichmäßig polarisiert ist, daß das Material des zweiten Teils (54) in der Richtung parallel zu der Kreissymmetrieachse (A) und in einem zweiten Richtungssinn, der zu dem ersten Richtungssinn entgegengesetzt ist, gleichmäßig polarisiert ist, und daß der Transformator eine gemeinsame Elektrode (55) aufweist, die zwischen dem ersten Teil (53) und dem zweiten Teil (54) des Körpers (52) angeordnet ist.

4. Piezoelektrischer Transformator nach einem der Ansprüche 2 und 3, **dadurch gekennzeichnet, daß** die mehreren primären Elektroden (5, 7, 10, 12, 17, 19, 22, 24, Fig. 4 und 8) umfassen:

   - eine erste primäre Elektrode (5) und eine zweite primäre Elektrode (7), die jeweils in bezug auf die erste Symmetrieebene (S1) symmetrisch sind, in bezug auf die zweite Symmetrieebene (S2) zueinander symmetrisch sind und beide in dem äußeren Teil der ersten Fläche (3; 56) des Körpers (2; 52) angeordnet sind;
   - eine dritte primäre Elektrode (10) und eine vierte primäre Elektrode (12), die jeweils in bezug auf die zweite Symmetrieebene (S2) symmetrisch sind, in bezug auf die Symmetrieebene (S1) zueinander symmetrisch sind und beide in dem inneren Teil der ersten Fläche (3; 56) des Körpers angeordnet sind; und

- eine fünfte (17), eine sechste (19), eine siebte (22) und eine achte (24) primäre Elektrode, die alle auf der zweiten Fläche (4; 57) des Körpers (2; 52) gegenüber der ersten (5), der zweiten (7), der dritten (10) bzw. der vierten (12) primären Elektrode angeordnet sind.

5. Piezoelektrischer Transformator nach Anspruch 4, **dadurch gekennzeichnet, daß** er Mittel (13, 15, 25, 27, Fig. 4 und 8) umfaßt, die die erste primäre Elektrode (5) und die dritte primäre Elektrode (10), die zweite primäre Elektrode (7) und die vierte primäre Elektrode (12), die fünfte primäre Elektrode (17) und die siebte primäre Elektrode (22) sowie die sechste primäre Elektrode (19) und die achte primäre Elektrode (24) elektrisch verbinden.

6. Piezoelektrischer Transformator nach Anspruch 4, **dadurch gekennzeichnet, daß** die mehreren sekundären Elektroden (6, 8, 9, 11, 18, 20, 21, 23, Fig. 4 und 8) wenigstens eine erste sekundäre Elektrode (6), die auf der ersten Fläche (3; 56) des Körpers (2; 52) zwischen der ersten primären Elektrode (5) und der zweiten primären Elektrode (7) angeordnet ist und in bezug auf die zweite Symmetrieebene (S2) symmetrisch ist, und eine zweite sekundäre Elektrode (18), die auf der zweiten Fläche (4; 57) des Körpers (2; 52) gegenüber der ersten sekundären Elektrode (6) angeordnet ist, umfassen.

7. Piezoelektrischer Transformator nach Anspruch 6, **dadurch gekennzeichnet, daß** die mehreren sekundären Elektroden (6, 8, 9, 11, 18, 20, 21, 23, Fig. 4 und 8) außerdem umfassen:

- eine dritte sekundäre Elektrode (8) und eine vierte sekundäre Elektrode (20), die auf der ersten Fläche (3; 56) bzw. auf der zweiten Fläche (4; 57) des Körpers (2; 52) einander gegenüber und in bezug auf die erste Symmetrieebene (S1) symmetrisch zu der ersten sekundären Elektrode (6) bzw. zu der zweiten sekundären Elektrode (18) angeordnet sind;
- eine fünfte sekundäre Elektrode (9) und eine sechste sekundäre Elektrode (21), die auf der ersten Fläche (3; 56) bzw. auf der zweiten Fläche (4; 57) des Körpers (2; 52) einander gegenüber angeordnet sind und sich zwischen der dritten primären Elektrode (10) und der vierten primären Elektrode (12) bzw. zwischen der siebten primären Elektrode (22) und der achten primären Elektrode (24) befinden; und
- eine siebte sekundäre Elektrode (11) und eine achte sekundäre Elektrode (23), die auf der ersten Fläche (3; 56) bzw. auf der zweiten Fläche (4; 57) des Körpers (2; 52) einander gegenüber und in bezug auf die zweite Symmetrieebene (S2) symmetrisch zur fünften sekundären Elektrode (21) bzw. zur sechsten sekundären Elektrode (21) angeordnet sind.

8. Piezoelektrischer Transformator nach Anspruch 4, **dadurch gekennzeichnet, daß** die mehreren sekundären Elektroden (6, 8, 9, 11, 18, 20, 21, 23, Fig. 4 und 8) wenigstens eine erste sekundäre Elektrode (9), die auf der ersten Fläche (3; 56) des Körpers (2; 52) zwischen der dritten primären Elektrode (10) und der vierten primären Elektrode (12) und in bezug auf die erste Symmetrieebene (S1) symmetrisch angeordnet ist, und eine zweite sekundäre Elektrode (21), die auf der zweiten Fläche (4; 57) des Körpers (2; 52) gegenüber der ersten sekundären Elektrode (9) angeordnet ist, umfassen.

9. Piezoelektrischer Transformator nach Anspruch 3, **dadurch gekennzeichnet, daß** die mehreren primären Elektroden (5 bis 12) umfassen:

- eine erste primäre Elektrode (5) und eine zweite primäre Elektrode (7), die in bezug auf die erste Symmetrieebene (S1) jeweils symmetrisch sind, in bezug auf die zweite Symmetrieebene (S2) zueinander symmetrisch sind und beide in dem äußeren Teil der ersten Fläche (56) des Körpers (52) angeordnet sind;
- eine dritte primäre Elektrode (10) und eine vierte primäre Elektrode (12), die in bezug auf die zweite Symmetrieebene (S2) jeweils symmetrisch sind, in bezug auf die erste Symmetrieebene (S1) zueinander symmetrisch sind und beide in dem inneren Teil der ersten Fläche (56) des Körpers (52) angeordnet sind;
- eine fünfte primäre Elektrode (6), die in bezug auf die zweite Symmetrieebene (S2) symmetrisch ist und zwischen der ersten primären Elektrode (5) und der zweiten primären Elektrode (7) angeordnet ist;
- eine sechste primäre Elektrode, die in bezug auf die erste Symmetrieebene (S1) zu der fünften primären Elektrode (6) symmetrisch ist;
- eine siebte primäre Elektrode (9), die in bezug auf die erste Symmetrieebene (S1) symmetrisch ist und zwischen der dritten primären Elektrode (10) und der vierten primären Elektrode (12) angeordnet ist; und
- eine achte primäre Elektrode (11), die in bezug auf die zweite Symmetrieebene (S2) zu der siebten primären Elektrode (9) symmetrisch ist.

10. Piezoelektrischer Transformator nach Anspruch 9, **dadurch gekennzeichnet, daß** er Mittel (13 bis 18, Fig. 9) umfaßt, die die erste (5) und die dritte (10) primäre Elektrode, die zweite (7) und die vierte (12) primäre Elektrode, die fünfte (6) und die achte (11) primäre Elektrode sowie die sechste (8) und die siebte (9) primäre Elektrode elektrisch verbinden.

**11.** Piezoelektrischer Transformator nach Anspruch 9, **dadurch gekennzeichnet, daß** die mehreren sekundären Elektroden (17 bis 24, Fig. 9) wenigstens eine erste (17, 19, 22, 24) und eine zweite (18, 20, 21, 23, Fig. 9) sekundäre Elektrode umfassen, die auf der zweiten Fläche (57) des Körpers (52) gegenüber einer der ersten (5), zweiten (7), dritten (10) und vierten (12) primären Elektroden bzw. gegenüber einer der fünften (6), sechsten (8), siebten (9) und achten primären Elektroden (11) angeordnet sind.

**12.** Piezoelektrischer Transformator nach Anspruch 9, **dadurch gekennzeichnet, daß** die mehreren sekundären Elektroden (17 bis 24, Fig. 9) acht sekundäre Elektroden (14 bis 24, Fig. 9) umfassen, die auf der zweiten Fläche (57) des Körpers (52) jeweils gegenüber einer der primären Elektroden (5 bis 12, Fig. 9) angeordnet sind.

**13.** Piezoelektrischer Transformator nach einem der Ansprüche 2 und 3, **dadurch gekennzeichnet, daß** der Körper (2; 52) die allgemeine Form einer Vollscheibe hat.

**14.** Piezoelektrischer Transformator nach einem der Ansprüche 2 und 3, **dadurch gekennzeichnet, daß** der Körper (2; 52) die allgemeine Form eines Rings hat, der eine innere seitliche Oberfläche (I) besitzt, die bei Nichtvorhandensein der Schwingung die Form eines zweiten kreisförmigen Zylinders hat, der zu dem ersten kreisförmigen Zylinder koaxial ist, wobei die innere seitliche Oberfläche (I) abwechselnd die Form eines dritten elliptischen Zylinders und die Form eines vierten elliptischen Zylinders annimmt, wenn die äußere seitliche Oberfläche (E) die Form des ersten elliptischen Zylinders bzw. die Form des zweiten elliptischen Zylinders annimmt, wobei der dritte elliptische Zylinder eine große Achse und eine kleine Achse besitzt, die zu der Kreissymmetrieachse (A) senkrecht sind und in der ersten (S1) bzw. in der zweiten Symmetrieebene (S2) liegen, und wobei der vierte elliptische Zylinder eine große Achse und eine kleine Achse besitzt, die zu der Kreissymmetrieachse (A) senkrecht sind und in der zweiten (S2) bzw. in der ersten (S1) Symmetrieebene liegen.

**Claims**

**1.** Piezoelectric transformer (1; 51) including:

- a body (2; 52) made of piezoelectric material having a first (3; 56) and a second (4; 57) face and an outer lateral surface (E);
- a plurality of primary electrodes (5, 7, 10, 12, 17, 19, 22, 24; 5 to 12) arranged on said body (2; 52) to cause said body (2; 52) to vibrate in response to a primary alternative voltage (Up; Up1, Up2); and
- a plurality of secondary electrodes (6, 8, 9, 11, 18, 20, 21, 23; 17 to 24) arranged on said body (2; 52) to generate a secondary voltage (Us) in response to said vibration;

said outer surface (E) having, in the absence of said vibration, the shape of a first circular cylinder having a circular axis of symmetry (A) and said faces (3; 4; 56, 57) each having an outer portion situated on the side of said outer lateral surface (E) and an inner portion surrounded by said outer portion, **characterised in that** said primary electrodes (5, 7, 10, 12, 17, 19, 22, 24; 5 to 12) are arranged so that, when said primary voltage (Up; Up1, Up2) has a frequency at least substantially equal to a determined frequency (fr), said outer lateral surface (E) alternately takes the shape of a first elliptical cylinder and the shape of a second elliptical cylinder, said first elliptical cylinder having a major axis and a minor axis perpendicular to said circular axis of symmetry (A) and respectively situated in a first plane of symmetry (S1) including said circular axis of symmetry and a second plane of symmetry (S2) perpendicular to said first plane of symmetry (S1) and also including said circular axis of symmetry (A), said second elliptical cylinder having a major axis and a minor axis perpendicular to said circular axis of symmetry (A) and respectively situated in said second plane of symmetry (S2) and said first plane of symmetry (S1), and, when said outer lateral surface (E) has the shape of one of said first and second elliptical cylinders, the respective major axis having a length which varies regularly increasing from a minimum value equal to the diameter of said circular cylinder to a maximum value then decreasing from said maximum value to said minimum value, said outer lateral surface (E) then taking the shape of the other of said first and second elliptical cylinders.

**2.** Piezoelectric transformer according to claim 1, **characterised in that** said body (2) is formed of a single part and **in that** said piezoelectric material is uniformly polarised in a direction parallel to said circular axis of symmetry (A) and in a direction going from one (3) to the other (4) of said first and second faces (3, 4) of said body (2).

**3.** Piezoelectric transformer according to claim 1, **characterised in that** said body (52) includes a first (53) and a second (54) part, **in that** the piezoelectric material of said first part (53) is uniformly polarised in a direction parallel to said circular axis of symmetry (A) and in a first direction going from one (56) to the other (57) of said first and second faces (56, 57) of said body (52), **in that** the material of said second part (54) is uniformly polarised in said direction parallel to said circular axis of symmetry (A) and in a second direction opposite to said first direction, and **in that** said transformer (51) includes a common electrode (55) arranged between said first (53) and said second (54) part of said body (52).

4. Piezoelectric transformer according to claim 2 or 3, **characterised in that** said plurality of primary electrodes (5, 7, 10, 12, 17, 19, 22, 24, Figures 4 and 8) includes;

   - a first (5) and a second (7) primary electrode each symmetrical with respect to said first plane of symmetry (S1), symmetrical to each other with respect to said second plane of symmetry (S2) and both arranged on said outer portion of said first face (3; 56) of said body (2; 52);
   - a third (10) and a fourth (12) primary electrode, each symmetrical with respect to said second plane of symmetry (S2), symmetrical to each other with respect to said first plane of symmetry (S1) and both arranged on said outer portion of said first face (3; 56) of said body; and
   - a fifth (17) a sixth (19), a seventh (22) and an eighth (24) primary electrode all arranged on said second face (4; 57) of said body (2; 52) facing said first (5), said second (7), said third (10) and, respectively, said fourth (12) primary electrode.

5. Piezoelectric transformer according to claim 4, **characterised in that** it includes means (13, 15, 25, 27, Figures 4 and 8) for electrically connecting said first (5) and said third (10) primary electrodes, said second (7) and said fourth (12) primary electrode, said fifth (17) and said seventh (22) primary electrodes, and said sixth (19) and said eighth (24) primary electrodes.

6. Piezoelectric transformer according to claim 4, **characterised in that** said plurality of secondary electrodes (6, 8, 9, 11, 18, 20, 21, 23; Figures 4 and 8) includes at least a first secondary electrode (6) which is arranged on said first face (3; 56) of said body (2; 52) between said first (5) and said second (7) primary electrode and is symmetrical with respect to said second plane of symmetry (S2), and a second secondary electrode (18) arranged on said second face (4; 57) of said body (2; 52) facing said first secondary electrode (6).

7. Piezoelectric transformer according to claim 6, **characterised in that** said plurality of secondary electrodes (6, 8, 9, 11, 18, 20, 21, 23; Figures 4 and 8) further includes:

   - a third (8) and a fourth (20) secondary electrode, arranged facing each other on said first (3; 56) and, respectively, on said second face (4; 57) of said body (2; 52) and respectively symmetrical to said first (6) and said second (18) secondary electrode with respect to said first plane of symmetry (S1); and
   - a fifth (9) and a sixth (21) secondary electrode arranged facing each other on said first (3; 56) and respectively, on second face (4; 57) of said body (2; 52), and situated between said third (10) and said fourth (12) primary electrode and, respectively, said seventh (22) and said eighth (24) primary electrode; and
   - a seventh (11) and an eighth (23) secondary electrode arranged facing each other on said first (3; 56) and, respectively, said second (4; 57) face of said body (2; 52) and respectively symmetrical to said fifth (9) and said sixth (21) secondary electrode with respect to said second plane of symmetry (S2).

8. Piezoelectric transformer according to claim 4, **characterised in that** said plurality of secondary electrodes (6, 8, 9, 11, 18, 20, 21, 23; Figures 4 and 8) includes at least a first secondary electrode (9) arranged on said first face (3; 56) of said body (2; 52) between said third (10) and said fourth (12) primary electrode and symmetrical with respect to said first plane of symmetry (S1), and a second secondary electrode (21) arranged on said second face (4; 57) of said body (2; 52) facing said first secondary electrode (9).

9. Piezoelectric transformer according to claim 3, **characterised in that** said plurality of primary electrodes (5 to 12) includes:

   - a first (5) and a second (7) primary electrode, each symmetrical with respect to said first plane of symmetry (S1), symmetrical to each other with respect to said second plane of symmetry (S2) and both arranged on said outer portion of said first face (56) of said body (52);
   - a third (10) and a fourth (12) primary electrode, each symmetrical with respect to said second plane of symmetry (S2), symmetrical to each other with respect to said first plane of symmetry (S1) and both arranged on said inner portion of said first face (56) of said body (52);
   - a fifth primary electrode (6) symmetrical with respect to said second plane of symmetry (S2) and arranged between said first (5) and said second (7) primary electrode;

- a sixth primary electrode (8) symmetrical to said fifth primary electrode (6) with respect to said first plane of symmetry (S1);
- a seventh primary electrode (9) symmetrical with respect to said first plane of symmetry (S1) and arranged between said third (10) and said fourth (12) primary electrode; and
- an eighth primary electrode (11) symmetrical to said seventh primary electrode (9) with respect to said second plane of symmetry (S2).

10. Piezoelectric transformer according to claim 9, **characterised in that** it includes means (13 to 16, Figure 9) for electrically connecting said first (5) and said third (10) primary electrode, said second (7) and said fourth (12) primary electrode, said fifth 86) and said eighth (11) primary electrode, and said sixth (8) and said seventh (9) primary electrode.

11. Piezoelectric transformer according to claim 9, **characterised in that** said plurality of secondary electrodes (17 to 24, Figure 9) includes at least a first (17, 19, 22, 24) and a second (18, 20, 21, 23, Figure 9) secondary electrode arranged on said second face (57) of said body (52) facing one of said first (5), second (7), third (10) and fourth (12) primary electrode and, respectively, facing one of said fifth (6), sixth (8), seventh (9) and eighth (11) primary electrode.

12. Piezoelectric transformer according to claim 9, **characterised in that** said plurality of secondary electrodes (17 to 24, Figure 9) includes eight secondary electrodes (17 to 24, Figure 9) arranged on said second face (57) of said body (52), each facing one of said primary electrodes (5 to 12, Figure 9).

13. Piezoelectric transformer according to claims 2 and 3, **characterised in that** said body (2; 52) has the general shape of a solid disc.

14. Piezoelectric transformer according to claims 2 and 3, **characterised in that** said body (2; 52) has the general shape of a ring including an inner lateral surface (I) having, in the absence of said vibration, the shape of a second circular cylinder coaxial with said first circular cylinder, said inner lateral surface (I) alternately taking the shape of a third elliptical cylinder and the shape of a fourth elliptical cylinder when said outer lateral surface (E) takes the shape of said first elliptical cylinder and, respectively, the shape of said second elliptical cylinder, said third elliptical cylinder having a major axis and a minor axis perpendicular to said circular axis of symmetry (A) and situated respectively in said first (S1) and in said second (S2) plane of symmetry, and said fourth elliptical cylinder having a major axis and a minor axis perpendicular to said circular axis of symmetry (A) and situated respectively in said second (S2) and in said first (S1) plane of symmetry.

Fig. 1

Fig. 2

Fig. 3

Fig. 4

EP 0 898 313 B1

Fig. 5

Fig. 6

Fig. 7

Fig. 8

Fig. 9

EP 0 898 313 B1